# EUROPEAN PATENT APPLICATION

(11) **EP 1 727 021 A1**
(43) Date of publication of application: **29.11.2006**
(21) Application number: 05425355.4
(22) Date of filing: 23.05.2005
(51) Int. Cl.: G06F 1/20, H05K 7/20

(54) **Redundancy ventilation system for Advanced Telecommunication Computing Architecture (ATCA)**

(71) Applicant: Siemens S.p.A., 20126 Milano (IT)
(72) Inventor: Mantegazza, Walter, 20040 Cambridge (MI) (IT); Ripamonti, Marco, 24020 Torre Boldone (BG) (IT)
(74) Representative: Giustini, Delio

(57) **Abstract**

A redundancy ventilation system for Advanced Telecommunication Computing Architecture (ATCA) includes an array of N+1 removable fans connected on the top of a cabinet including on-board electrical components generating heat to be extracted from the cabinet. Outlet openings for the passage of the hot air flow are provided in the cabinet in correspondence of each fan. Inlet openings for the environmental air are provided in the bottom. Each fan is opposite to a respective vent comprising an approximately square frame fastened to the inner surface of top wall at the border of the opening. A plurality of elongated substantially flat blades (5) are arranged parallelly to each other inside the frame. The blades are hinged (9) on two opposite sides of the frame so as to be pivotable either by the air flow to an open position or by gravity to a closed position covering the entire frame when the fan is broken down. The faulty fan can be hot removed in this way. A plenum is arranged between the vent and the most adjacent electrical components to influence in equalizing the pressure of the passing air flow. The blades have a sloped extension (5b) for intercepting the air flow in the open position of the blades (5) and generating a contrasting momentum M2 in a direction opposite to the direction of the momentum M1 generated by the gravity force on the blades (5). The blade extension (5b) is shaped in such a way that momentum M2 due to the minimum pressure of the air flow on the exposed surface balances, or exceeds, the momentum M1. The fans are commanded to vary their rotational speed to match with different choices, e.g.: to supply the contribute of the faulty fan, or on the basis of the tolerated acoustic noise. In case of variable speed the sloped extension (5b) introduces an hysteretic behaviour in the blades closure with respect to the pressure of the air flow (fig.8).

## Description

### FIELD OF THE INVENTION

The present invention relates to the cooling system for electronic components in a cabinet, and more precisely to a redundancy ventilation system for Advanced Telecommunication Computing Architecture (ATCA).

### BACKGROUND ART

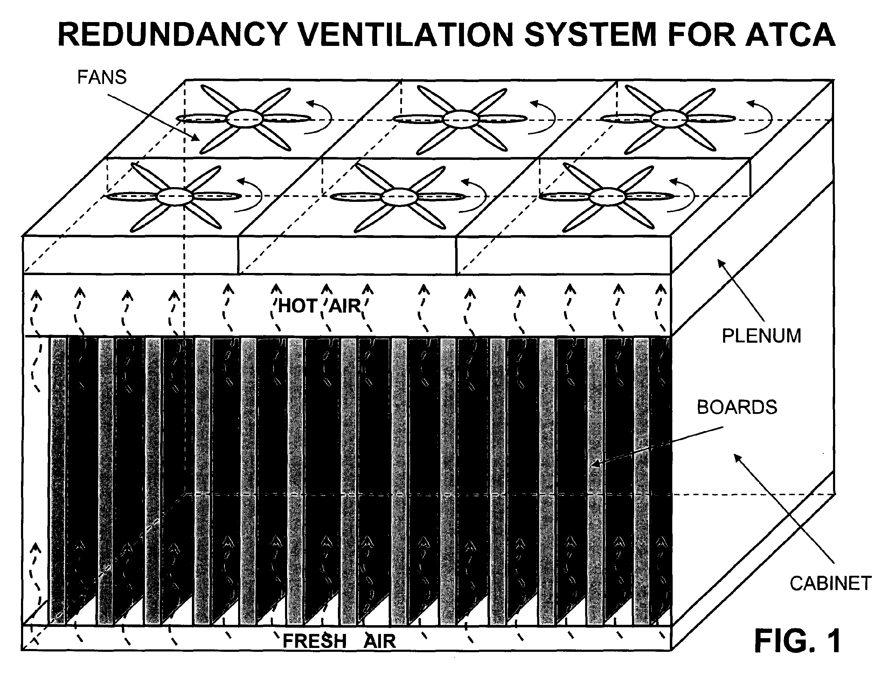

**Fig.1** shows a redundancy ventilation system for ATCA without any particular means for neutralizing the side effect of a faulty fan. The ATCA system comprises a cabinet including a shelf (not visible) hosting a certain number of boards. The boards have surface mounted electrical (electronic) components generating heat to be removed from the cabinet to avoid overheating. The boards are interconnected on the backplane (not shown) and opportunely spaced to each other for allowing air circulation therein. An array of six fans is visible in the upper part of the cabinet for generating a cooling air flow through the cabinet. A free space, named plenum, is created inside the cabinet between the fans and the boards to the aim of equalizing the pressure of the passing air flow. Swirls are reduced by the plenum and the stability of the air flow is improved consequently. In the depicted embodiment, with the fan system on the top, the environmental air is sucked up through air inlets (not shown) on the bottom wall of the cabinet and the hot air is expelled on the top through the fan blades; in such a case the plenum is a depression space. An alternative embodiment has the fan system on the bottom wall of the cabinet and the air outlet on the top; in such a case the plenum on the bottom between the fans and the boards is a high pressure space. In other alternative embodiments, mostly used in computer systems, fans are placed at the end wall, but frontal or side fans are also possible. The safety cooling is a problem of utmost importance in the ATCA systems because they are very compact and characterized by high thermal power density dissipation (e.g.: about 40 W/dm³). The array of six fans constitutes a N+1 redundancy system designed to neutralize the side effect of a faulty fan. During normal operation the N+1 fans run simultaneously to move an air flow greater than the minimum necessary for cooling the boards, thus if a fan fails the remaining flow is still enough to the cooling purposes.

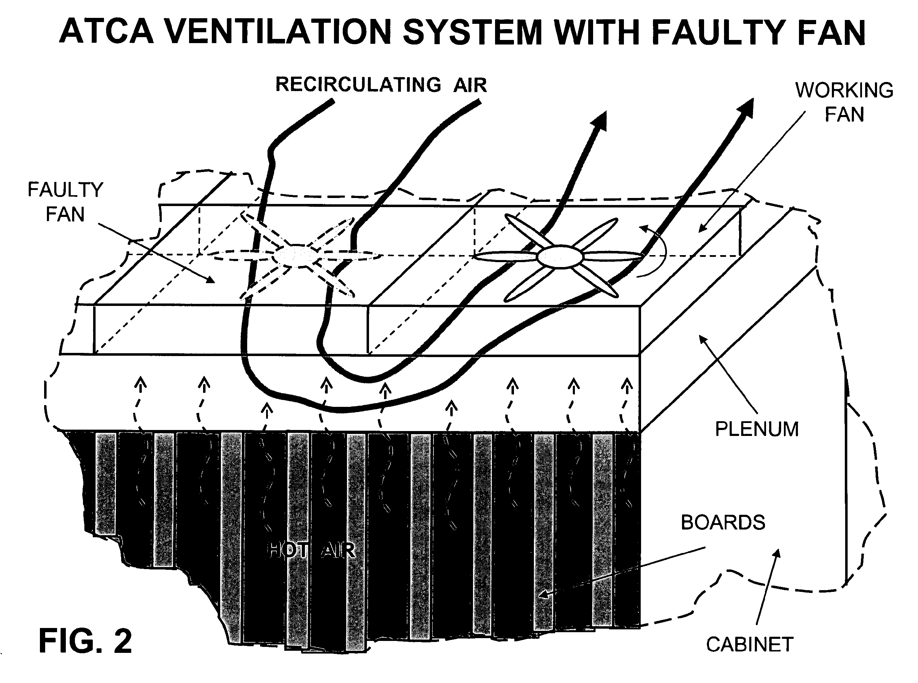

**Fig.2** shows a partial view of the preceding ATCA system with a broken down fan. Unfortunately, without other known expedients that will be described soon, the supplying action of the adjacent fans is reduced. The side effects is depicted by two thick arrows indicating the path taken by the external air through the blades of the faulty fan, the plenum, and the outlet of the adjacent working fans. Thermal generation inside the cabinet creates higher impedance to air flow so that the arrows indicates a low impedance path for the external air. As a result, the recirculating air through the failed fan mingles in the plenum with the hot air coming from inside the cabinet, and the hot air flow is reduced at the inlet of an adjacent working fan, consequently. The reduced cooling capacity may cause dangerous hot spots. The most popular expedient to overcome this drawback is that of automatically closing the opening in the cabinet faced to a fan as soon as the fan goes wrong, blocking in this way the recirculating air. Suitable closing means are in the form of pivotable blades (also termed in the literature: slates, baffles, vanes, louvre-boards, (U.S: louver), etc.).

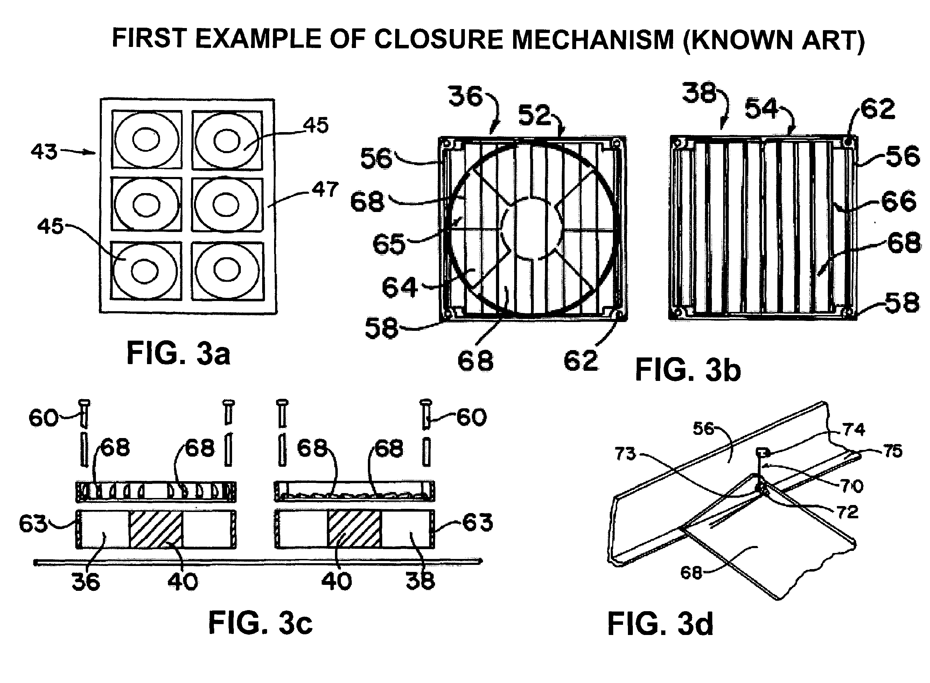

**Fig.3a-3d** are taken from the US 6,011,689 patent, titled: "COMPUTER COMPONENT COOLING FAN CLOSURE DEVICE AND METHOD THEREOF". **Fig.3a** shows a fan tray 43 having an attaching surface 47 for supporting six fans 45. **Figures 3b** and **3c** show two vent-vane assemblies 52 and 54 for two respective fans 36 and 38 seen from the side of the components. Each assembly includes a square shaped thin sheet metal or plastic vent 56 taking the form of a parameter frame 58 having an interior side open to the associated fan having blades 64, and its opposite side open to the interior of the computer. Mounted within the frame 58 of the vents 52 and 54 are vane assemblies 65 and 66. Each vane assembly comprises a series of rotational parallelly arranged slats 68, that in their closed position cover the entire opening of the vents. As indicated in **Fig.3c**, each vent is secured by four fasteners 60, i.e. either screws or bolts, to the rear side of the associated fan, for which purpose the vents have corner holes 62 that align with four corresponding holes (not shown) in the sheet metal or plastic housing 63 of the associated fan and by which means the vents are tightly secured to the fans. The exploded representation indicates the central rotors 40 of fan 36 and 38 with slats 68 opened on the left and closed on the right. The slats are constructed and arranged to be forced to pivot to open position by the fan airflow and pivot to closed position either by gravity or elastic force, or both. **Fig.3d** shows the vent 56 supporting a pivot metal or plastic pin 72 for the rotation of slat 68 and a return spring assembly 70 for a steel spring 73 engaged to the slat 68 and a stop 74 contacting an inside edge of a wall 75 of the vent 56. The fan tray 43 can be mounted either at the front side or the back of the computer, the fans can either push or pull air over the components in combination with outlet/inlet openings in the other side.

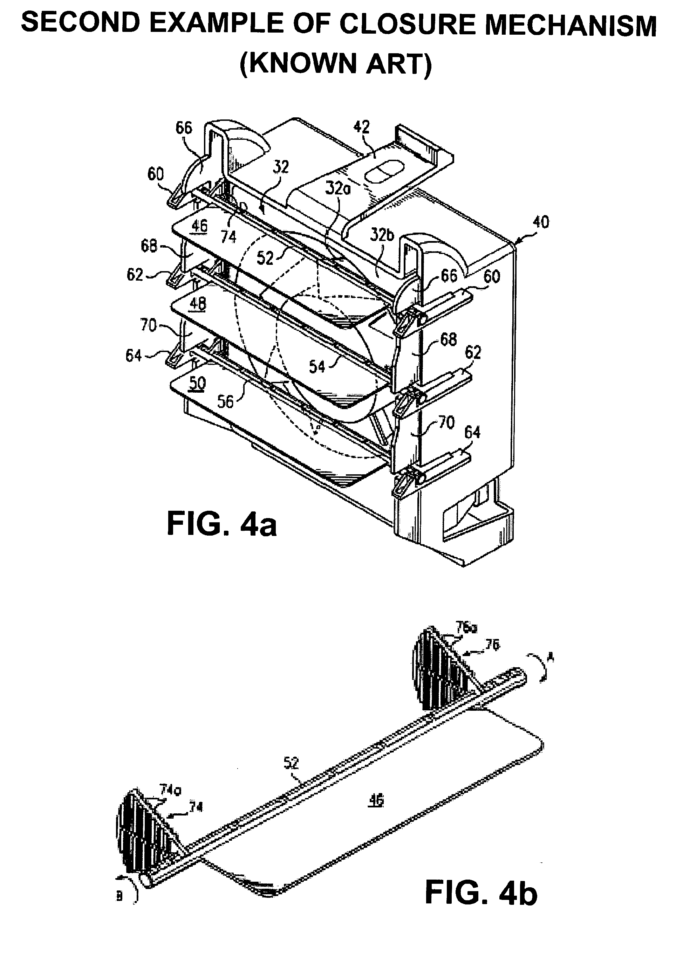

Another embodiment of redundancy cooling system is disclosed in the US 6,005,770 patent titled: "COMPUTER AND SYSTEM AND METHOD FOR COOLING THE INTERIOR OF THE COMPUTER". **Figures 4a** and **4b** are reported from this document. In **fig.4a** a partial fan assembly relevant to a single fan 32 is shown in perspective view. The assembly is constituted by a housing 40 including the fan 32 and three vertically spaced louvers 46, 48 and 50 extending horizontally across the housing 40 (the louvers are depicted in their open position). Three horizontally extending shafts 52, 54 and 56 are disposed along the rear edge of respective louvers. As better shown in **fig.4b,** in connection with the louver 46 and its corresponding shaft 52, a longitudinal edge of the louver is attached to the shaft along a portion of the shaft extending parallel to the axis of the shaft. Two counterweights 74 and 76 are mounted to the respective end portions of the shaft 52 at areas diametrically opposed to the area to which the louver 46 is attached. The other louvers as their shafts are constructed in the same manner. In **fig.4a** three pairs of support brackets 60, 62, and 64 are mounted in the housing 40 with one bracket of each pair being mounted to one side wall of the housing 40 and with the other bracket of each pair being mounted to other side wall of the housing. The respective end portions of the shafts are mounted in the pairs of brackets. As a result of above, the shafts can rotate in the support brackets causing corresponding pivotal movement of the louvers. Three pair of plates 66, 68 and 70 are mounted on the front edge portion of the sidewalls of the housing 40 immediately above the louvers. These plates direct the air flow through the fan towards the louvers.

In operations, referring to **fig.4b,** it is noted that the gravitational force caused by the weight of the louver 46 applies a torque, or rotational force, to the shaft 52 in the direction indicated by the arrow A. The counterweights 74 and 76 are sized and constructed so that the resultant gravitational force applies a torque to the shaft 52 in a direction indicated by the arrow B, which is opposite to the direction A. The design is such the torque applied to the shaft 52 by the louver 46 is just slightly greater than that applied to the shaft by the counterweights 74 and 76. Therefore when the fan 32 is inoperable, the louver 46 (and the other louvers) will pilot down to the vertical closed position, this prevents any backflow of air through the fan 32 and thus eliminates any interference with the normal air flow through the functioning fans. When the fan 32 is turned on, the resulting air pressure created by the fan is sufficient to force the louver 46 (and the other louvers) to its horizontal open position. The effect of the counterweights is that only a slight increase of the air flow through the fan is needed to pivot the louvers to their horizontal open position.

### OUTLINED TECHNICAL PROBLEMS

A defect of the fan closure device of the firstly cited US patent (only considering closure by gravity) is that the advantage introduced by closed slats is vanished during the substitution of a failed fan, with that increasing the risk of components failure. The vane assemblies 65 and 66 are screwed to the housing 63 of the associated fan, so that during fan replacement the inlet/outlet vent 56 remains open offering low impedance path to the external air. Further considering the risk for the apparatus deriving form the mechanical manoeuvres for dismounting the faulty fan and remounting a new one, a safety rule might be to switch off the computer during this replacement. But in telecommunication systems traffic cannot be lost either for a fan failure or during their serviceability, this means that the boards previously cooled down by the faulty fan cannot be switched off.

The louver closure device of the secondly cited US patent has the same defect of the firstly cited US patent plus the drawback that manufacturing counterbalanced louvers is costly and their housing is cumbersome by way of the side counterweights which limit the number of blades to only few ones.

Furthermore, the two cited embodiments are not apparently oriented to manage fans with variable rotational speed and the consequent variable pressure of the cooling air flow.

Hereafter, to avoid linguistic confusion and make the description of the invention uniform, the term "blade" is used to indicate the pivotable parts of the closure mechanism, and "momentum" is used instead of torque.

Before introducing the invention it is useful point out that the fan positions with respect to the walls of the cabinet, so as the use of fans either to extract hot air from the cabinet or force the external air on the surface of the components, are quite indifferent for a closure mechanism based on the effect of the gravity force on pivotable blades. In fact, whatever configuration is chosen to stream air on the hot components, it is always possible find a settlement to pivot and stop the blades in such a way to employ the air flow to open the blades, after witch the closed position is reached automatically by the motion of the blades towards a minimum energy point.

### OBJECTS OF THE INVENTION

The present invention is aimed to overcome the defects of the prior art. A first object of the invention is that to indicate a redundancy ventilation system particularly suitable for ATCA systems having a closure mechanism provided with little sized and cost-effective means for keeping the blades open with minimum pressure of the air flow. A second object of the invention is that to allow variability of the rotational speed of the fan blades to meet with various design choices, preferably for trading off the desired grade of redundancy with the requested cooling power performance. This should be a different criterion to introduce redundancy in respect of the known N+1 simultaneously working fans. Furthermore, if second object were pursued together with the first one simultaneously, a hysteretic behaviour of the closure mechanism in respect of the pressure of the air flow could be obtained. Other object of the invention is that to indicate a redundancy ventilation system for ATCA completely modular, such as to allow the hot replacement of a faulty blocking the recirculating air flow even during the replacement without switching off the apparatus.

### SUMMARY AND ADVANTAGES OF THE INVENTION

The invention achieves said objects by providing a redundancy ventilation system for cooling electrical components generating heat in a cabinet, as disclosed in claim 1.

According to a first embodiment of the invention, the ventilation system includes at least two fans arranged adjacent to each other, each fan is faced to a respective opening in a cabinet wall for generating a cooling air flow through it. Each fan is faced to a respective vent assembly comprising an approximately square frame sufficiently high to include a plurality of parallelly arranged elongated and substantially flat blades hinged at opposite sides of the frame. The blades are forced to pivot to an open position by the pressure of the fan air flow or automatically to a closed position in absence of air flow by effect of the momentum generated by the gravity force on the blades. In closed position the blades are covering the entire opening of the vent. The blades shortly extend beyond their axis of rotation for all their length. The extension of the blades, called hereafter tail, is opportunely sloped for intercepting the air flow according to an angle useful to generate a momentum in a direction opposite to the direction of the momentum generated by the gravity force on the blade. By effect of the tails, the open position of the blades hold on even at the minimum pressure of the air flow. The tail is shaped and sized so that in the open position of the blade the momentum due to the only minimum permissible pressure of the air flow on the exposed surface of the tail balances the momentum due to the weight of the blade. The short tail by effect of its own weight could constitute a sort of counterweight, but the momentum generated by the gravity force on the short tail is negligible with respect to the momentum in the same direction generated by the air pressure on its sloped surface. It must be said that in case the tail were not properly sloped, the contrary effect could be obtained by the air flow; to say a contribute to the blade closure instead of their aperture. It can be appreciated that a well different mechanism is exploited in comparison with the counterweights of **fig.4b.** The proposed solution based on the only action of the air flow on opportunely sloped tails is independent of the fan positions with respect to the walls of the cabinet. Considerable advantages of this embodiment are the opportunity to design narrower and lighter blades, and hence less expensive, together with a mechanically simpler and cheaper housing for them.

According to a second embodiment of the invention, the fans are commanded to vary the rotational speed of their blades to match with different choices. During normal operation all fans are working at a certain speed lower than their maximum target but still enough for safety cooling. When a fan breaks down the remaining fans increase their speed to supply the contribute of the faulty fan. This is performed automatically thanks to well known temperature and blade rotation sensors, jointly to shut off devices and means for varying the rotational speed of the fans either mechanically or electrically. For example, different fan speeds allow to trade off between the desired grade of redundancy and the requested cooling power performance, provided that at least two fans are initially mounted and the two fans are simultaneously working. We point out that this is a different criterion to introduce redundancy in respect of the classical N+1 redundancy mentioned in the introduction relatively to the ATCA system of fig.1. The advantage on the new criterion is that during normal operation the cooling capacity is not over-dimensioned by effect of the redundant fan. Furthermore, the speed can be varied on the basis of the tolerated acoustic noise in the limits of safety cooling. In all cases in which fans with different speeds are used, thanks to the effect of the aforementioned tails the pivotable blades stand up in open position even during ventilation at the lowest speed, so as to make the cooling anyway reliable and generate a hysteretic behaviour with respect to the variability on the pressure of air flow. By comparison, the counterweights of the prior art are used with fans working at constant speed and only for raising the heavy louvers faster, not to the aim of the present invention of maintaining the pivotable blades still open with the lowest possible fan speed.

According to a third embodiment of the invention, the vent is a square metallic frame fastened to the inside wall of the cabinet delimiting an opening for the air flow, and the respective fan is connected to the outer side of the wall in hot removable manner. The advantage of this embodiment is that to easily remove a faulty fan and replace it without shut off the apparatus and without opening the closed vent.

### BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:
- **fig.1,** already described, shows a redundancy ventilation system for ATCA according to the known art;
- **fig.2,** already described, shows the system of fig.1 in case of break down of a fan;
- **figures 3a-3d,** already described, show a first example of a closure mechanism usable in a redundancy ventilation system according to the prior art;
- **figures 4a and 4b,** already described, show a second example of closure mechanism usable in a redundancy ventilation system according to the prior art;
- **fig.5** shows a perspective view of a redundancy ventilation system according to the present invention;
- **fig.6** is a schematic representation of a cross-section along axis A-A of fig.5;
- **fig.7** shows a perspective view (not in scale) of a blade 5 of the ventilation system of fig.5 in its horizontal closed position;
- **fig.8** shows a perspective view (not in scale) of a blade 5 of the ventilation system of fig.5 in its vertical open position;
- **figures 9a and 9b** show a cross-section along axis A-A of fig.5, represented in two separate parts for reasons of space.

### DETAILED DESCRIPTION OF AN EMBODIMENT OF THE INVENTION

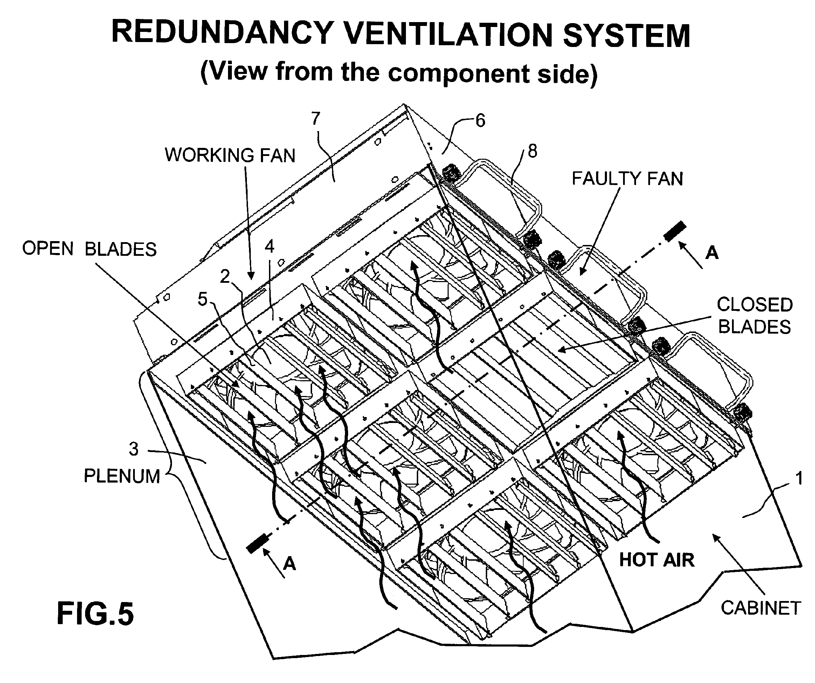

As a description rule, in the several figures of the drawings like referenced numerals identify like elements. Besides, the various elements represented in the figures are not a scaled reproduction of the original ones. With reference to **fig.5** we see a cabinet 1 containing a shelf of boards (not shown) with surface mounted electronic components generating heat to be dissipated. Without limitation, the cabinet and the boards constitute an ATCA system similar to the one of fig.1. On the top of the cabinet a ventilation system is visible in perspective view, seeing from the internal of the cabinet, constituted by six fans 2 disposed in two adjacent rows of three adjacent fans. The top wall has six square openings in correspondence of the fans 2 to allow drawing hot air from the cabinet 1, so that fresh air moves from the external into the cabinet through inlets on the bottom walls (not visible) by effect of the depression generated by fans 2. The six square openings are outlets for the exhaust air coming from a depression zone 3 similar to the plenum of fig.1. Each square outlet is framed by a vent 4, either metallic or plastic, fastened to the inside top wall of cabinet 1 by known fastening means, e.g. screws, bolts, welding. The vent 4 includes six flat blades 5 disposed parallelly to each other and elongated for all the width of the vent 4. The blades 5 are hinged at the two sides of the vent 4 so as to be pivotable between an open and a closed position. The width and the spacing of blades 5 are such that in their closed position they cover the whole area of the vent 4 blocking in this way the air flow through the respective fan 2. The vent 4 and the hinged blades 5 constitute a vent assembly. The constructional features of the vent assembly are such that blades 5 are pivoted by gravity in their closed position and forced to pivot to open position by the air flow generated by fan 2. For example, the edge of the square vent 4 delimits a square window with sides shorter than the length of the blade 5, in order to stop the blade parallelly to the window during its rotation towards the minimum energy point.

Constructional details of blades 5 will be described in successive figures. Fans 2 are inserted in respective drawers 6 located in a mechanical housing 7 fixed to the outer top wall of cabinet 1. Fan drawers 6 can be inserted and extracted in/from the housing 7 by means of handles 8. Plug and socket electrical contacts are arranged between fans 2 and the housing 7. A faulty fan is shown in figure, curved arrows indicate possible paths of the hot air flow. The passive closure of the blades 5 below the faulty fan, due to the lack of airflow through it, blocks automatically the recirculating air from the external through the blades of the wrong fan and the plenum 3. The vent outlet of the faulty fan remains closed even after removal of the fan, so as to enabling hot replacement. In operation, the rotational speed of the fan blades can be varied either in discrete steps by the operator or continuously by a feedback temperature regulator. The pressure of the air flow against the surface of blades 5 increases with the increasing of the rotational speed of the fan blades; with that, a question of utmost importance is that blades 5 stand up in their open position also with the minimum pressure of the air flow at the outlet of fan 2 (corresponding to the maximum depression inside the plenum 3).

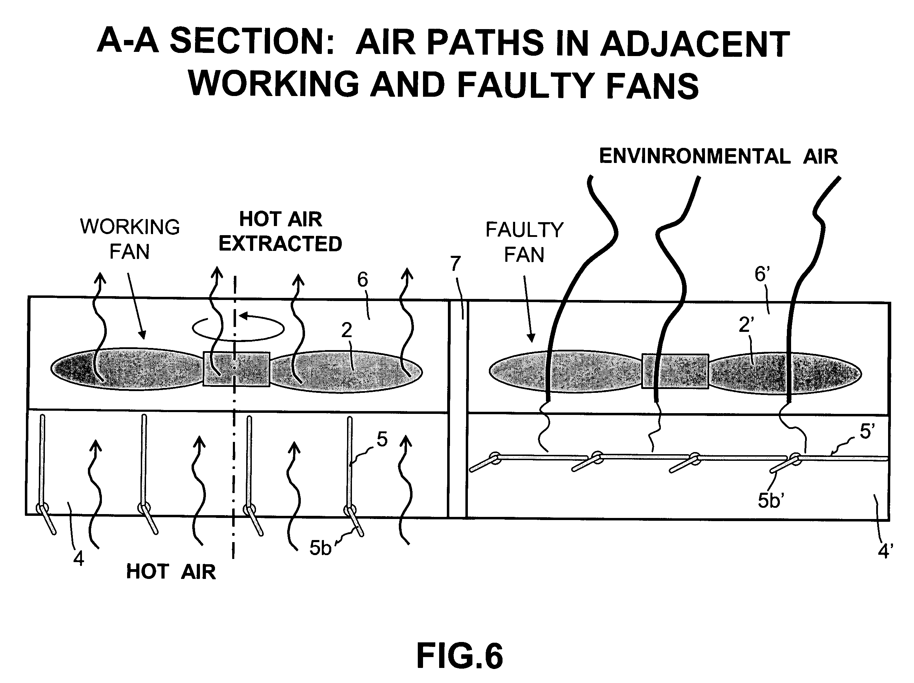

With reference to **fig.6**, left half of the figure, a fan 2 is depicted inside its drawer 6 of the housing 7. Fan 2 is working to move the exhaust air from the outlet vent 4 to the external through the open position of blades 5. In the right half of the figure a faulty fan 2' is depicted inside its drawer 6' of the housing 7. The environmental air is intercepted and blocked by the closed blades 5' inside the vent 4', wile the hot air previously directed to the faulty fan 6' is equalized in the plenum and redirected towards the working fan 6. The blades 5 and 5' have a short sloping tail 5b and 5b' which extends other their hinging points. As will be explained soon, these tails allow the blades to stand up in their open position with the minimum pressure of the air flow at the outlet of fan 2. Moreover in case of very high speed of the air flow, the blades 5 and the plenum 3 contribute to reduce vortexes and make the air flow more laminar, providing great benefit in lowering the system impedance curve of the cooling system.

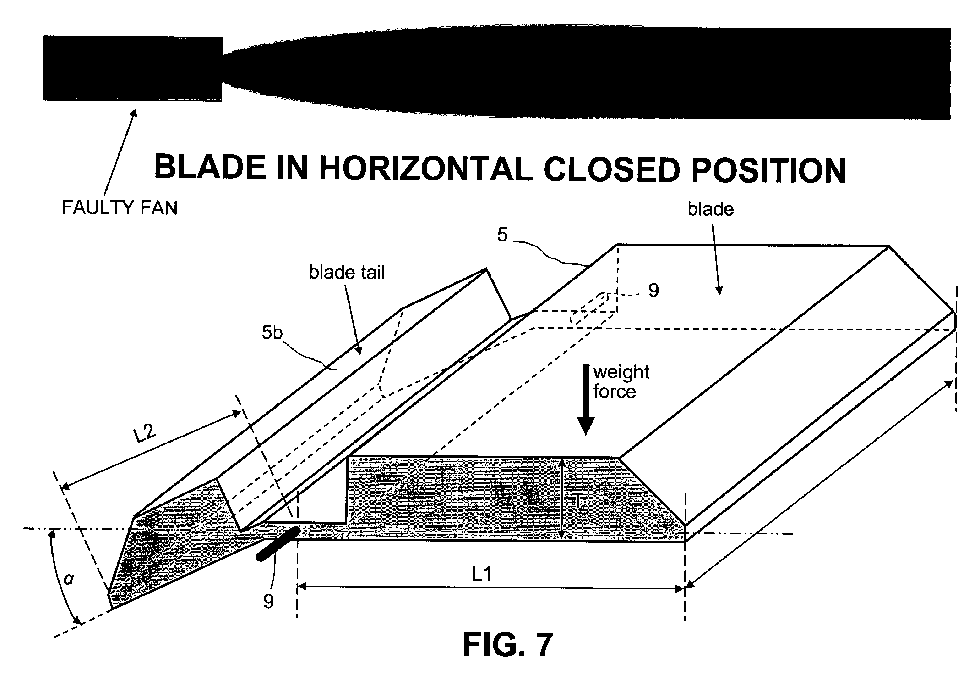

**Fig.7** shows a blade 5 with its sloped tail 5b in horizontal closed position under the blades of a faulty fan. The thickness T of the blade 5 is deliberately exaggerated to put the shape in foreground in the perspective view. With reference to the figure, we see that the blade 5a and the tail 5b are part of a single metallic body having a part 5c of reduced thickness delimiting the blade 5 from its tail 5b for the whole length L of the two parts. Two pivots 9 are inserted at the two sides of the delimiting part 5c in diametrically opposite points to make the blade pivotable inside the frame of vent 4. The tail 5b is sloped by an angle α < 90° in respect of the blade 5 as indicated in the figure. The width of blade 5, from the pivot 9 to its end, is indicated by L1; the width of tail 5b, from the pivot 9 to its end, is indicated by L2. In the real case, number and dimensions of the blades 5, so as the slope of tail 5b, are specific for each implementation depending on space and dimension of the fans.

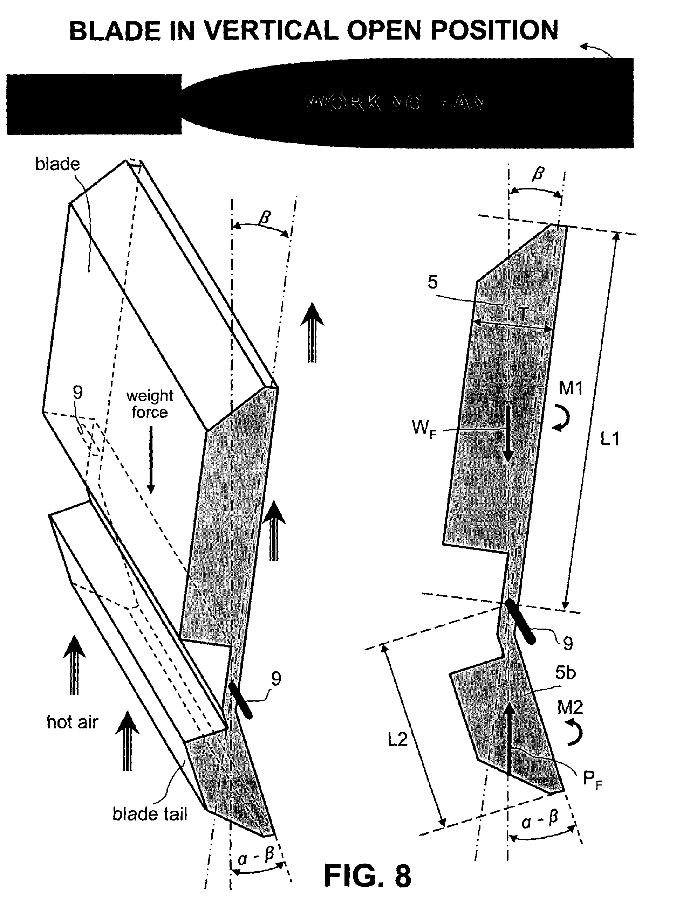

**Fig.8** shows a blade 5 in vertical open position under a fan working to extract hot air from the cabinet. Thick arrows indicate the direction of the air flow. For convenience the short side face of the blade is reported in the right part of the figure. With reference to the figure, the vertical open position of blade 5 is reached or maintained with the minimum pressure of the air flow at the outlet of the fan. Two curved arrows indicate the momentum M1 generated by the weight force and the momentum M2 generated by the pressure of the air flow on the exposed surface of tail 5b, respectively. The weight force is applied in the gravity centre of blade 5, while the resultant of the pressure forces is applied nearly at the centre of the exposed face of tail 5b. The letter has a blunted edge to increase the exposed surface. Assuming that blades 5 in their open position are slightly sloped of an angle β < α in respect of the direction of the air flow, corresponding to the vertical in the non limiting example. The mathematical condition by which the momentum M2 contrasts M1 is **M2 ≥ M1**. With reference to **fig.8,** M1 and M2 are approximately calculated as in the following:
- W_{F} is the weight force exercised by the gravity on the blade 5. W_{F} = Volume x material density D = length x width x depth x material density = L x L1 x T x D.
- The force W_{F} is applied to the gravity centre of the blade 5, placed at a distance about ½ L1 from the pivot 9.
- **M1** = W_{F} x ½ L1 x sin β = (L x L1 x T x D) x ½ L1 x sin β.
- S is the effective surface of the blade tail 5b exposed to the air flow. S = L x L2 (but the increment to the surface due to the blunted edge should be also considered).
- P_{F} is the force exercised by the air flow at the minimum pressure (PaMin) over the effective surface S of the blade tail 5b. After that:
- **M2** = P_{F} x L2 x sin (α-β) = PaMin x L x L2 x sin (α-β).
Some indicative numerical value are: L1 = 14.5 mm; L2 = 7.2 mm; α = 25°.

Now the functional condition on the slope of tail 5 which is needed to have a contrasting momentum is analyzed starting from a blade 5 in its completely open position in the direction of the air flow. Let' suppose as positive an angle subtended by the blade in its rotation towards the closed position departing from the open position, then the tail slope angle determined by the intersection of a plane parallel to the blade 5 with a plane parallel to the tail 5b shall be as much lower than 180° as the desired contrasting momentum increases, until a maximum in correspondence of an angle of approximately 90° is reached.

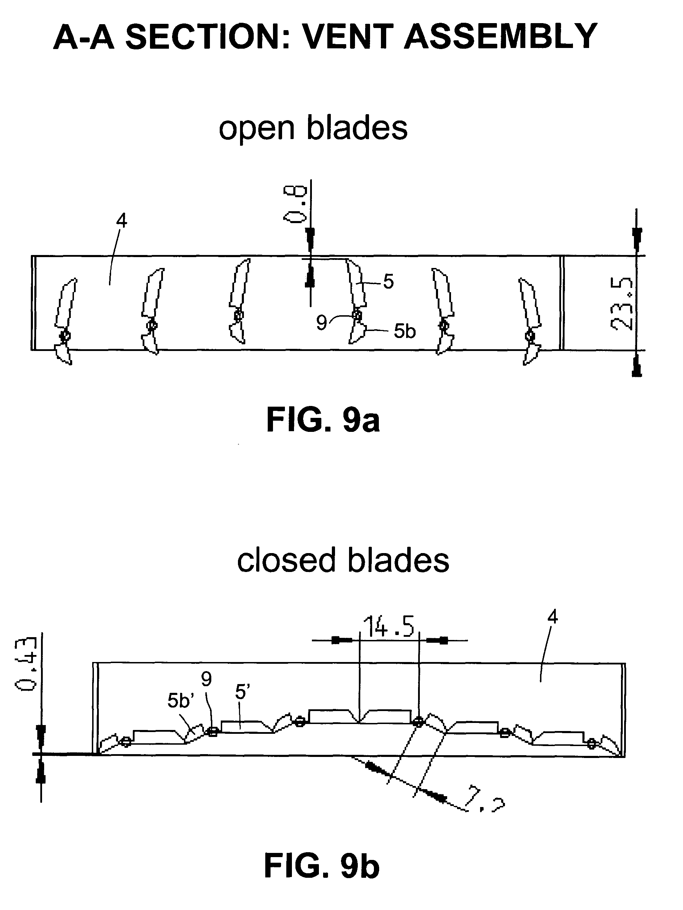

**Fig.9a** and **9b** show a cross-section along axis A-A (fig.5) representing two adjacent vents 4 each including six blades in their open and closed positions, respectively. With reference to **fig.9a**, the three leftmost blades of each group are pivoted counterclockwise to be open by the air flow, while the remaining three rightmost blades are pivoted clockwise. With reference to **fig.9b,** the three leftmost blades of each group are pivoted clockwise to be closed by gravity, while the remaining three rightmost blades are pivoted counterclockwise. This trick allows a partial superimposition of blades 5' to tails 5b', and vice versa, in closed position with half the total displacement between the first and the sixth hinging points of pivots 9.

## Claims

1. A redundancy ventilation system for cooling electrical components generating heat in a cabinet (1), including:
- at least two fans (2) arranged adjacent to each other for generating an air flow trough respective inlet and outlet openings in the cabinet walls;
- each fan (2) being faced to a respective vent (4) comprising an approximately square frame (4) delimiting a respective opening for the passage of the air flow;
- a plurality of elongated substantially flat blades (5) arranged parallelly to each other inside said frame (4) and hinged (9) on two opposite sides of the frame (4) so as to be turned either to an open position by the pressure of air flow or to a closed position covering the entire frame by effect of the momentum generated by the gravity force when the faced fan (2') is faulty;
- a plenum arranged inside the cabinet (1) between the vent (4) and the most adjacent electrical components to influence in equalizing the pressure of the passing air flow;
- means (5b) rigidly connected to said blades beyond their axis of rotation (9) for generating a contrasting momentum (M2) in a direction opposite to the direction of the momentum (M1) generated by the gravity force on said blades (5),
**characterized in that**:
- said means for generating the contrasting momentum (M2) is constituted by a blade extension (5b) shaped in such a way that said momentum (M2) in presence of the minimum permissible pressure of the air flow on the exposed surface of the extension (5b) when said blades (5) are in their open position balances or exceeds said momentum (M1) generated by the gravity force.

2. The redundancy ventilation system of the claim 1, **characterized in that** said extension (5b) is sloped in respect of the blade (5) by an angle lower than 180° intercepted by the intersection between a plane parallel to the blade (5) and a plane parallel to its extension (5b) on condition that an angle is considered as positive in the direction of the blade rotation towards the closed position starting from its open position in the direction of the air flow.

3. The redundancy ventilation system of the claim 2, **characterized in that** said angle is as much lower than 180° as the desired contrasting momentum is increased until the maximum in correspondence of an angle of approximately 90° is reached.

4. The redundancy ventilation system of any preceding claim, **characterized in that** the edge of said extension (5b) is blunted for increasing the exposed surface.

5. The redundancy ventilation system of any preceding claim, **characterized in** said frame (4) is fastened to the inner surface of the cabinet at the border of the respective opening, being the associated fan (2) connected to the outer surface of the wall (6, 7) so as to be removable (8) in case of failure letting the blades (5) in their closed position.

6. The redundancy ventilation system of any preceding claim, **characterized in that** during normal operation all fans (2) are working at a certain speed lower than their maximum target but still enough for safety cooling.

7. The redundancy ventilation system of the claim 6, **characterized in that** the fans (2) are commanded to vary the rotational speed of their blades to match with different choices.

8. The redundancy ventilation system of the claim 7, **characterized in that** when a fan (2') breaks down, the remaining fans (2) are commanded to automatically increase their rotational speed to supply the contribute of the faulty fan (2').

9. The redundancy ventilation system of the claim 7, **characterized in that** the fans (2) are commanded to vary their rotational speed on the basis of the tolerated acoustic noise, in the limits of safety cooling.

10. The redundancy ventilation system of any preceding claim, **characterized in that** a first subset of half successive blades (5) are pivoted in a first direction, while a second subset of the remaining blades are pivoted in the opposite direction, to allow in closed position a partial superimposition at the two ends of each blade (5) inclusive of its extension (5b) halving the total displacement between the first and the last hinging points of pivots (9).

11. The redundancy ventilation system of any preceding claim, **characterized in** said fans are on the top wall of said cabinet (1) and work to extract hot air from the respective said opening for the air flow.

12. The redundancy ventilation system of any preceding claim, **characterized in that** is used in equipment manufactured according to Advanced Telecommunication Computing Architecture or ATCA systems.
